# EUROPEAN PATENT SPECIFICATION

(11) **EP 1 461 811 B1**
(45) Date of publication and mention of the grant of the patent: **29.03.2006**
(21) Application number: 02781031.6
(22) Date of filing: 05.12.2002
(51) Int. Cl.: G11C 15/04

(54) **LOW POWER CONTENT ADDRESSABLE MEMORY ARCHITECTURE**
ASSOZIATIVSPEICHERARCHITEKTUR MIT GERINGEM LEISTUNGSVERBRAUCH
ARCHITECTURE DE MEMOIRE ADRESSEE DE CONTENU (CAM) DE FAIBLE PUISSANCE

(30) Priority: 28.12.2001 US 342750 P; 30.04.2002 CA 2384039
(43) Date of publication of application: 29.09.2004
(73) Proprietor: Mosaid Technologies Incorporated, Kanata, Ontario K2K 2X1 (CA)
(72) Inventor: KIM, Jin-Ki, Ottawa, Ontario K2K 2Z7 (CA); VLASENKO, Peter, Kanata, Ontario K2L 3E1 (CA); PERRY, Douglas, Markham, Ontario, L3P 3L4 (CA); GILLINGHAM, Peter, B., Kanata, Ontario K2K 2K9 (CA)
(74) Representative: Mohun, Stephen John
(86) International application number: PCT/CA2002/001865
(87) International publication number: WO 2003/056564

(56) References cited:
- US-B1- 6 191 970
- US-B1- 6 243 280
- GHOSE K ET AL: "RESPONSE PIPELINED CAM CHIPS: THE FIRST GENERATION AND BEYOND" PROCEEDINGS OF THE INTERNATIONAL CONFERENCE ON VLSI DESIGN, XX, XX, 5 January 1994 (1994-01-05), pages 365-368, XP002049055

## Description

### FIELD OF THE INVENTION

The present invention relates to content addressable memories (CAM). More particularly the invention relates to a CAM architecture for reducing power consumption.

### BACKGROUND OF THE INVENTION

In many conventional memory systems, such as random access memory, binary digits (bits) are stored in memory cells, and are accessed by a processor that specifies a linear address that is associated with the given cell. This system provides rapid access to any portion of the memory system within certain limitations. To facilitate processor control, each operation that accesses memory must declare, as a part of the instruction, the address of the memory cell/cells required. Standard memory systems are not well designed for a content based search. Content based searches in standard memory require software based algorithmic search under the control of the microprocessor. Many memory operations are required to perform a search. These searches are neither quick nor efficient in using processor resources.

To overcome these inadequacies an associative memory system called Content Addressable Memory (CAM) has been developed. CAM allows cells to be referenced by their contents, so it has first found use in lookup table implementations such as cache memory subsystems and is now rapidly finding use in networking systems. CAM's most valuable feature is its ability to perform a search and compare of multiple locations as a single operation, in which search data is compared with data stored within the CAM. Typically search data is loaded onto search lines and compared with stored words in the CAM. During a search-and-compare operation, a match or mismatch signal associated with each stored word is generated on a matchline, indicating whether the search word matches a stored word or not. A typical word of stored data includes actual data with a number appended header bits, such as an "E" bit or empty bit for example, although the header bits are not specifically searched during search-and-compare operations.

A CAM stores data in a matrix of cells, which are generally either SRAM based cells or DRAM based cells. Until recently, SRAM based CAM cells have been most common because of their simple implementation. However, to provide ternary state CAMs, ie. where each CAM cell can store one of three values: a logic "0", "1" or "don't care" result, ternary SRAM based cells typically require many more transistors than ternary DRAM based cells. As a result, ternary SRAM based CAMs have a much lower packing density than ternary DRAM based cells.

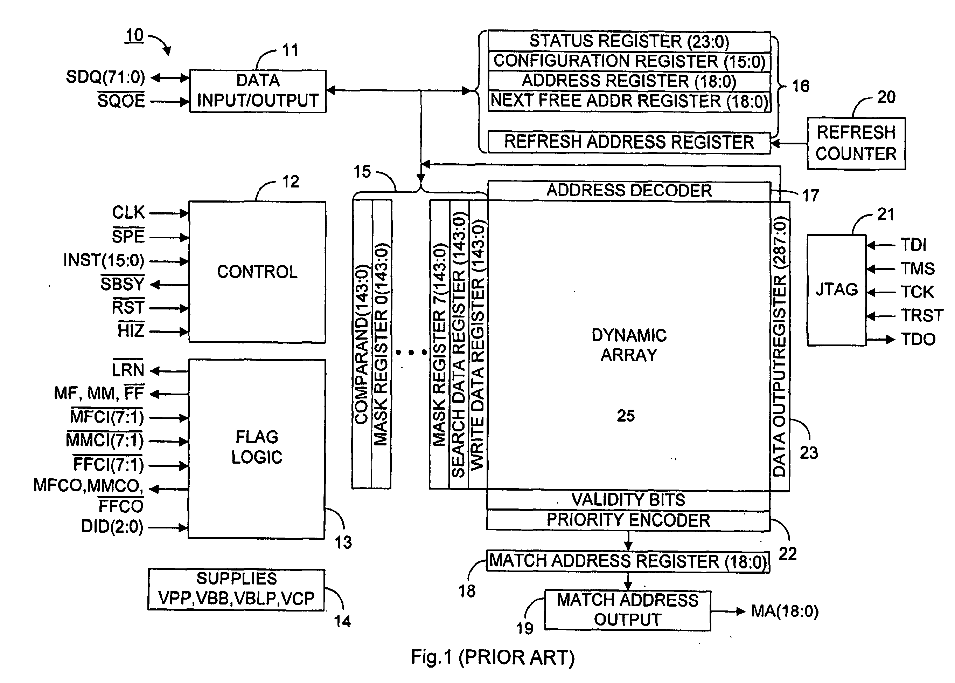

A typical CAM block diagram is shown in Figure 1. The CAM 10 includes a matrix, or array 25, of DRAM based CAM cells (not shown) arranged in rows and columns. An array of DRAM based ternary CAM cells have the advantage of occupying significantly less silicon area than their SRAM based counterparts. A predetermined number of CAM cells in a row store a word of data. An address decoder 17 is used to select any row within the CAM array 25 to allow data to be written into or read out of the selected row. Data access circuitry such as bitlines and column selection devices, are located within the array 25 to transfer data into and out of the array 25. Located within CAM array 25 for each row of CAM cells are matchline sense circuits, which are not shown, and are used during search-and-compare operations for outputting a result indicating a successful or unsuccessful match of a search word against the stored word in the row. The results for all rows are processed by the priority encoder 22 to output the address (Match Address) corresponding to the location of a matched word. The match address is stored in match address registers 18 before being output by the match address output block 19. Data is written into array 25 through the data I/O block 11 and the various data registers 15. Data is read out from the array 25 through the data output register **23** and the data I/O block 11. Other components of the CAM include the control circuit block 12, the flag logic block 13, the voltage supply generation block 14, various control and address registers 16, refresh counter 20 and JTAG block 21.

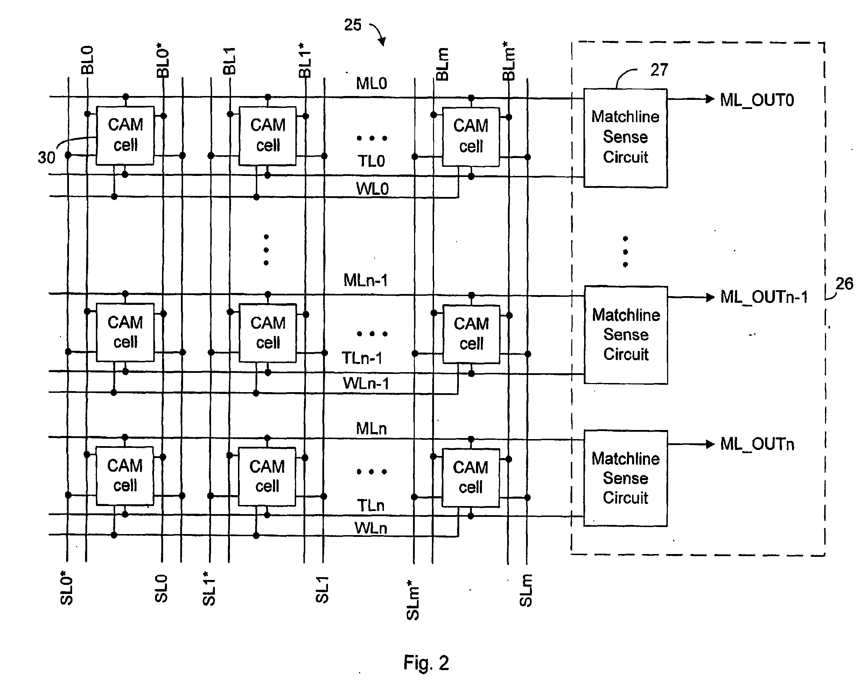

Figure 2 depicts a hierarchical view of the typical CAM array 25. CAM array 25 includes a matrix of CAM cells 30 and a matchline sense circuit block 26. CAM cells 30 of the CAM array 25 are arranged in rows and columns. CAM cells 30 of a row are connected to a common matchline **MLi,** word line **WLi** and tail line **TLi,** and CAM cells. 30 of a column are connected to a common pair of search lines **SLj*/SLj** and a common pair of bitlines **BLj/BLj*,** where i is an integer value between 0 and n, and j is an integer value between 0 and m. Located adjacent to the CAM array 25 for each row is matchline sense circuit block **26.** Matchline sense circuit block **26** includes one matchline sense circuit **27** connected to a respective matchline **MLi,** and is used during search-and-compare operations for outputting match signals **ML_OUT0-ML_OUTn** which indicate a successful or unsuccessful match of a search word against the stored word. Matchlines **MLi** and tail lines **TLi** are connected to their respective matchline sense circuits **27,** and tail lines **TLi** can be selectively connected to ground potential. Although not shown in the simplified schematic of Fig. 2, the matchline sense circuits **27** also receive control signals to control their operation, and a person skilled in the art would understand that such control signals to be necessary for their proper operation of the circuit.

Figure 3 shows a typical ternary DRAM type CAM cell **30** as described in issued United States Patent No.6,320,777 B1 . Cell **30** has a comparison circuit which includes an n-channel search transistor **31** connected in series with an n-channel compare transistor **32** between a matchline **ML** and a tail line **TL.** A search line **SL*** is connected to the gate of search transistor 31. The storage circuit includes an n-channel access transistor **33** having a gate connected to a wordline **WL** and connected in series with capacitor **34** between bitline **BL** and a cell plate voltage potential **VCP.** Charge storage node **CELL1** is connected to the gate of compare transistor **32** to turn on transistor **32** if there is charge stored on capacitor **34** i.e. if CELL1 is logic "1". The remaining transistors and capacitor replicate transistors **31, 32, 33** and capacitor **34** for the other half of the ternary data bit, and are connected to corresponding lines **SL** and **BL*** and are provided to support ternary data storage. Together they can store a ternary value representing logic "1", logic "0", or "don't care".

| Ternary Value | CELL1 | CELL2 |
|---|---|---|
| 0 | 0 | 1 |
| 1 | 1 | 0 |
| "Don't Care" | 0 | 0 |

The tail line **TL** is typically connected to ground and all the transistors are n-channel transistors. The description of the operation of the ternary DRAM cell is detailed in the aforementioned issued patent 6,320,777 B1.

As matchlines become longer with increasing memory densities, so does the parasitic capacitance for the longer matchlines. The additional loading of the matchlines due to the increased parasitic capacitance presents several design problems associated with matchline sensing. First, the current of a single conduction path produced by a non-matching CAM cell between the matchline and VSS is approximately 10µA. Hence the matchline sense amplifier must be sensitive enough to detect this small current. Second, the operating frequency of the CAM chip should be high, in other words, the working cycle of the matchline sense amplifier should be as short as possible to attain high CAM performance. Third, because all matchlines of the CAM chip are active at the same time during search-and-compare operations, the matchline voltage swing should be kept as low as possible to minimize power dissipation. Fourth, sensing should be stable and have good sensing margins for reliable sensing. Fifth, the matchline sense amplifier circuit should be simple and small enough to fit into a tight pitch CAM core layout to minimize area consumption and resulting cost. Even though the voltage swing on matchlines is kept low, power consumption still remains high due to the fully parallel searches executed by the CAM. One of the fundamental challenges for high capacity CAM's is minimizing power consumption due to the repeated charging and discharging of match lines during search and compare operations. The power consumption of the CAM increases proportionally as the memory capacity is increases.

There are two main sources of substantial power consumption during search operations in CAM's. Power consumed by match lines and power consumed by search lines. Conventionally, all match lines are precharged to a logic 'H' state (a match condition), and then the comparison with search data is allowed to pull match lines to a logic 'L' state (a miss condition).

In most CAM applications "misses" occur more frequently than "hits". Precharging match lines to a logic 'H' and discharging match lines to logic 'L' for misses tends to generate high power consumption due to the high current associated with charging and discharging all match lines for each search operation. In addition, with an increased number of cells connected to each match line for wider-word CAM applications, the capacitance of match lines increases accordingly, which in turn increases the current required to charge and discharge the match lines. Various solutions have been proposed for reducing the power consumed during search operations, such as segmenting match lines into multiple segments and activating segments sequentially based on match or miss results of previous segments.

For example, a segmented match line architecture is described in U.S. Patent No. 6,243,280 (Wong et al.)., wherein rows of the CAM are partitioned into a plurality of segments. For each match line, the first of the plurality of match line segments is precharged and a search operation is performed on the first segment. In case of a match in the first segment, the second match line segment is selectively precharged and searching proceeds to the second segment. If there is a match in the second segment, a third segment is precharged and searching proceeds in a similar manner until all segments of a match line have been searched. Precharging of a subsequent segment therefore only occurs in case of a match result in a previous segment. In the case of a match in all segments, selective precharging each segment to a logic 'H' however still requires a large current. Furthermore, a significant delay is introduced in the search time by having to wait for the selective precharge to occur in a segment before proceeding with the actual comparison in that segment.

In U.S. Patent No. 6,191,970 (Pereira) a match line is divided into multiple segments all of which are simultaneously precharged to a logic 'H' state prior to beginning a search operation. In addition, each CAM cell has an associated discharge circuit for selectively discharging its corresponding match line segment in response to a disable signal from a previous match line segment. A segment therefore is only discharged if the immediately preceding segment results in a miss while all subsequent segments remain precharged to a logic 'H'. As a result, the miss condition of one segment is propagated along the remainder of the row without discharging all other segments along the row. While this approach alleviates the problem of delays introduced by selectively precharging segments, the potential for high current consumption still remains, since all match lines must first be precharged to a logic 'H' state. In addition, the match detect of each segment must be synchronized to a clock signal, clocked since the match line precharges to a hit. As a result, either a number of internal clocks must be generated, or the system clock must be used which increases system latency. Finally, in order to prevent discharge before the segment is enabled a series coupled device is added to each CAM cell, thereby increasing chip area and slowing down the entire operation.

In an article entitled "Use of Selective Precharge for Low Power on the Match Lines of Content Addressable Memories" by Zukowski et al. IEEE 1997 there is described a method whereby a small segment of an overall match line is precharged and used to perform a partial comparison first and only if a match occurs in that first small segment is the remaining segment of the match line precharged and eventually searched. The article also suggests that theoretically the selective precharge technique could be extended to cover more than one stage, but the additional overhead, extra clock phases and additional buffering would not provide any large additional gains over the single stage selective precharge proposed therein. This approach does not consider the possibility of having multiple match line segments working sequentially but independently of clock cycles, providing a sufficiently fast process technology is available to implement the necessary circuitry. Furthermore, the approach discussed by Zukowski et al. still relies on a precharge to a logic 'H' state which can draw large amounts of current as previously explained.

Hence current CAM devices are not suitable for low power applications where conservation of battery power is critical. Thus there is still a need for a CAM which is capable of consuming less power during search operations than conventional search techniques.

### SUMMARY OF THE INVENTION

It is an object of the present invention to obviate or mitigate at least one disadvantage of previous CAM arrays. In particular, it is an object of the present invention to provide a content addressable memory architecture and method of operation that has reduced power consumption and that operates at high speed.

In a first aspect, the present invention provides a content addressable memory array. The content addressable memory array includes a matchline divided into a plurality of segments, where each of the plurality of segments is simultaneously precharged to a precharge voltage level in a precharge phase. The content addressable memory array also includes a matchline sense amplifier associated with each of the segments for sensing current from its associated segment in a sensing phase, where one matchline sense amplifier enables another matchline sense amplifier when a match condition is detected by the one matchline sense amplifier.

In an embodiment of the present aspect, timing circuits control precharge and sensing operations of the matchline sense amplifiers, and the timing circuits include reference matchlines. In another embodiment of the present aspect, the precharge voltage level corresponds to a miss condition that corresponds to a voltage level of ground.

In yet another embodiment of the present aspect, the matchline includes a first and a second matchline segment and the matchline sense amplifier associated with the first matchline segment enables the matchline sense amplifier associated with the second matchline segment. In an aspect of the present embodiment, the first matchline segment is coupled to fewer content addressable memory cells than the second matchline segment.

In another embodiment of the present aspect, the output of each matchline sense amplifier is stored in a latch circuit.

In a second aspect, the present invention provides a method of searching a content addressable memory having a plurality of rows of CAM cells, where each row has first and second matchline segments. The method includes the steps of precharging the first and second match line segments to a potential level corresponding to a miss condition during a precharge phase, establishing a biasing potential on the first matchline segment in each row of CAM cells during a sensing phase, sensing current in the first matchline segment during the sensing phase, and selectively enabling sensing of current in the second matchline segment in each row of CAM cells if the sensed current in the first matchline segment corresponds to a match condition between the search data and the stored data.

In an embodiment of the present aspect, the step of selectively enabling sensing includes converting the sensed current into a sense node output voltage. In yet another embodiment of the present aspect, the step of selectively enabling sensing includes latching the sense node output voltage for pipelined sensing of current in the first and the second matchline segments.

Other aspects and features of the present invention will become apparent to those ordinarily skilled in the art upon review of the following description of specific embodiments of the invention in conjunction with the accompanying figures.

### BRIEF DESCRIPTION OF THE DRAWINGS

Embodiments of the present invention will now be described, by way of example only, with reference to the attached Figures, wherein:
Figure 1 is a block diagram of a conventional CAM device;
Figure 2 is a block diagram of a portion of the CAM array of Figure 1;

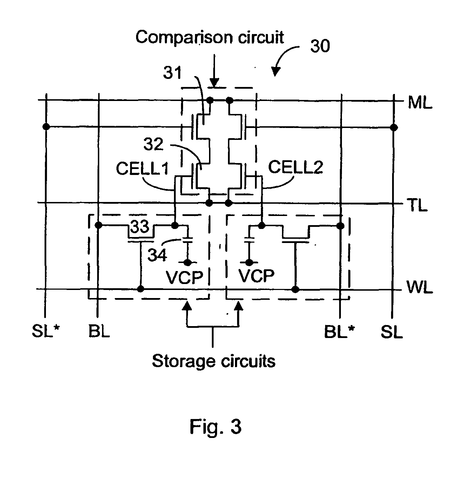

Figure 3 is a circuit schematic of a DRAM based CAM cell;
Figure 4 is a simplified block diagram of a segmented matchline CAM array according to an embodiment of the present invention;
Figure 5 is a schematic of a segmented matchline and associated sense amplifiers according to an embodiment of the present invention;
Figure 6 is flow chart illustrating a method of performing a search in the segmented matchline CAM array embodiment of Figures 4 and 5;
Figure 7 is a block diagram illustrating an embodiment of the low power CAM architecture according to an embodiment of the present invention;
Figure 8 is a circuit schematic of the matchline sense amplifiers of Figure 7;
Figure 9 is a circuit schematic of the latches of Figure 7;
Figure 10 is a timing diagram illustrating pipelining search operations in a CAM employing one segmented matchline embodiment of the present invention;
Figure 11 is a circuit schematic of a control block for generating signals controlling the matchline sense amplifier circuit of Figure 8;
Figure 12 is a circuit schematic of hardwired miss and hit matchline blocks; and,
Figure 13 shows a circuit schematic of a reference current source for providing a reference current to the matchline sense amplifier circuit of Figure 8.

### DETAILED DESCRIPTION

A low power CAM architecture is disclosed. Matchlines of the CAM array are segmented into two search portions: a pre-search portion and a main search portion. After issuing a search command, a first search operation is conducted on the pre-search portion of the matchline, i.e. a pre-search is conducted. If the result of the pre-search is a match, then a second search is subsequently conducted on the main search portion of the matchline; i.e. a main search is subsequently conducted. If the result of pre-search is a mismatch, then the main search portion is disabled and no main search is conducted, and as a result, there is no power dissipation on the main search portion of the matchlines. Pre-search and main search operations can be pipelined to maintain high throughput with minimum latency. Power consumption is further reduced by using a matchline sense circuit for detecting a current on the pre-search and main search portions of the matchline. Matchlines are decoupled from the sense circuit sense node in order to achieve higher sensing speed and improved sense margins, and dummy matchlines are used to generate timed control signals for latching the output of the matchline sense circuits. All matchline segments are initially precharged to a miss condition, and are then set to a bias voltage prior to sensing. Although only two matchline segments are described, it will be appreciated by someone skilled in the art that multiple segments could be formed.

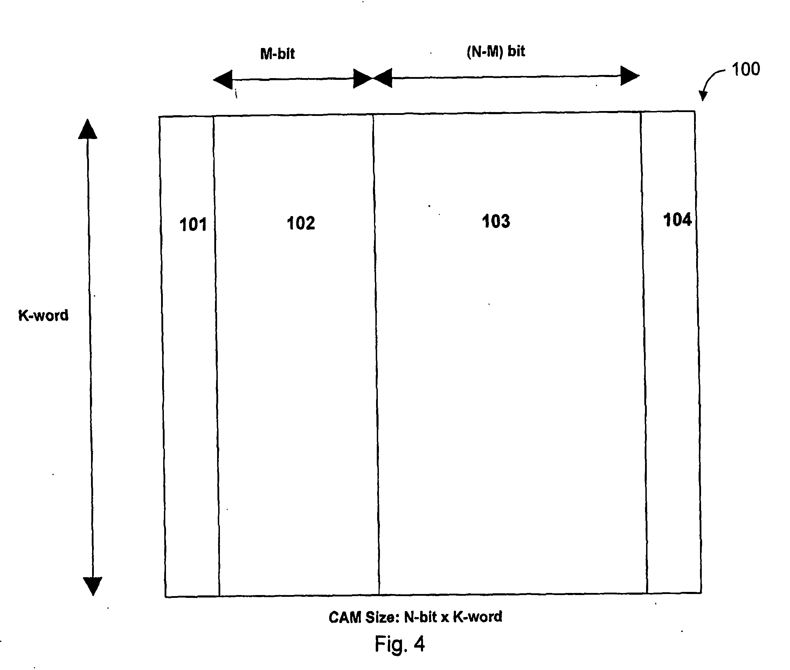

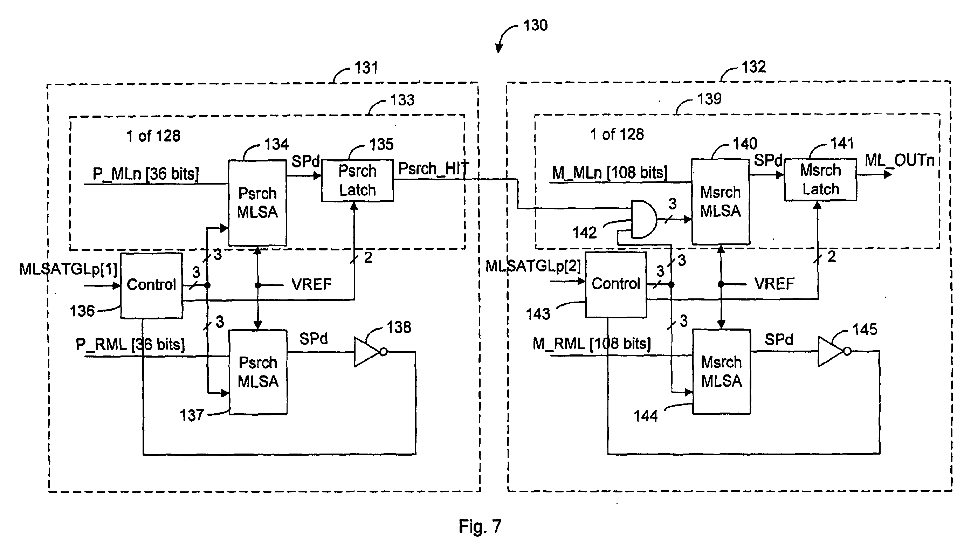

Figure 4 shows the general low power CAM cell array architecture according to an embodiment of the present invention. It will be noted by those skilled in the art that Figure 4 represents a conceptual illustration of a CAM cell array, since the physical implementation would involve dividing the overall CAM into a plurality of quadrants and sub-blocks. The conceptual CAM cell array **100** of Figure 4 includes N columns and K rows. Each word (i.e. row) includes N-bits. Therefore the memory capacity is N-bit x K-word. According to one embodiment of the invention, the CAM cell array is divided into two parts; a pre-search cell array 102 and a main-search cell array **103.** Array **100** includes a pre-search matchline sense amplifier block 101 for sensing the pre-search matchlines of the pre-search cell array **102,** and a main-search matchline sense amplifier block **104** for sensing the main matchlines in the main -search cell array **103.** The pre-search matchlines of the pre-search cell array **102** are physically distinct from the main matchlines of the main search cell array **103.** Although not shown in Figure 4, the CAM array also includes dummy rows and logic circuits for controlling the matchline sense amplifiers. The dummy rows and logic circuits will be shown and discussed later with reference to Figure 7.

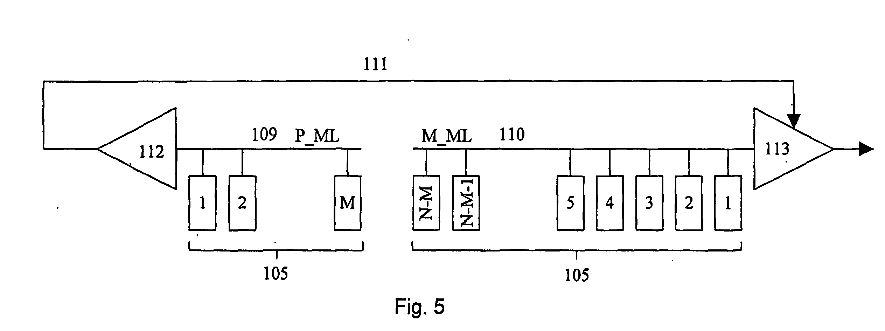

Figure 5 shows a simplified schematic of a segmented row and its associated segmented matchline for the CAM array of Figure 4. M number of CAM cells **105** are connected to a pre-search match-line **109** labelled **P_ML** and the pre-search match-line is sensed by pre-search matchline sense amplifier **112.** N-M number of CAM cells **105** are connected to a main-search match-line **110** labelled **M_ML** and the main-search match-line is sensed by main-search sense amp **113.** The output **111** of pre-search sense amp **112** either enables or disables main-search sense amp 113 depending on whether a match or a mismatch occurred in the pre-search segment. CAM cells 105 can be any type of CAM cell such as SRAM, DRAM or ternary SRAM and DRAM CAM cells. Those of skill in the art will understand that the matchline row of Figure 5 has been simplified, and that searchlines, wordlines and power supplies are coupled to the CAM cells **105.**

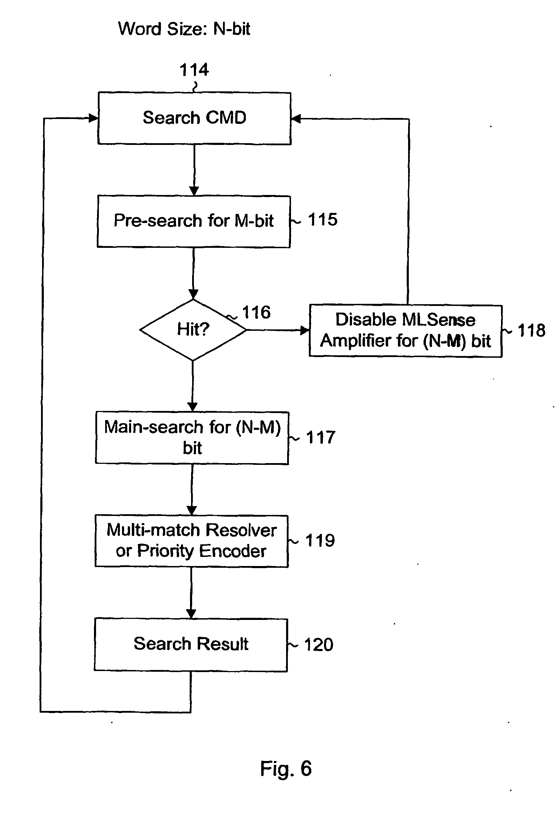

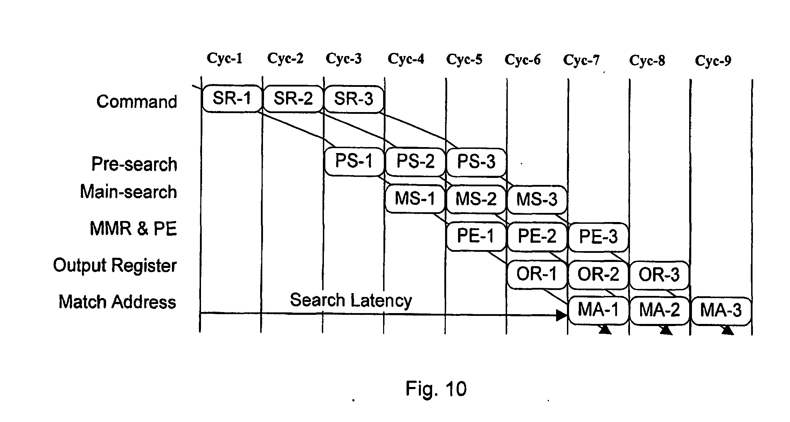

The flow chart of Figure 6 illustrates the operation of each segmented matchline row according to an embodiment of the present invention. At step **114,** an external search command is received by the CAM device. At step **115,** the CAM then internally initiates a pre-search operation on the M-bit segment of the matchlines. At step 116 the result of the pre-search is evaluated, and if a hit is detected in the pre-search portion, then the process proceeds to step **117.** Otherwise if a mismatch is detected in the pre-search portion, then processing continues with step **118.** Step **118** results in the sense amplifier for the main search portion being disabled and placing the device in a state to receive a new search command. Step **117** continues with a main search operation of the main search segment. Step **119** provides main search matchline sensing results to a multiple-match resolver and priority encoder. Step **120** provides highest priority match result output from priority encoder as an output from the CAM device and returns the device to a state where it is ready to receive a new search command. It should be noted that this process has been described without any pipelining function implemented. By using pipelining, a new pre-search operation for example could be started at step **114** while a main search operation is completing its steps in steps **117-120.** This pipelining approach is discussed in more detail with reference to Figure 10, and would allow more searches to be performed at a higher system clock speed. Thus by segmenting the matchlines, power is saved because any matchline exhibiting a mismatch in it pre-search portion will not charge and discharge its main search portion since the matchline as a whole will result in a mismatch.

Both Figures 4 and 5 illustrate the general layout of the matchline sense amplifiers with respect to their matchlines according to one embodiment of the present invention. In alternate embodiments, the main matchline sense amplifiers **113** can be placed on the opposite end of main matchline **110** to reduce the length of the line carrying the output **111.** In yet another alternate embodiment, both the pre-search matchline sense amplifier **112** and the main search matchline sense amplifier **113** can be placed adjacent to each other to minimize the length of the line carrying output **111.**

Therefore, the previously described segmented matchline architecture can reduce power consumption when compared to prior art CAM devices that do not have segmented matchlines. The embodiments of the present invention shown thus far can be applied to CAM devices employing any type of sensing scheme. More specifically, conventional CAM devices employ sensing schemes where the matchlines are precharged to a hit condition, such as high potential levels such as VDD for example. Therefore, the segmented matchline embodiments of the present invention can help conserve power by inhibiting precharge of the main search matchline and activation of the main matchline sense amplifiers, resulting in activation of only a subset of the array for the main search.

According to another embodiment of the present invention, optimum power savings can be achieved by employing a sensing scheme where the matchlines are precharged to a miss (mismatch) condition.. Generally, a precharge-to-miss sensing scheme involves precharging matchlines to the miss condition (can be either ground or logic high, depending on the type of compare transistors used in the CAM cell), asserting the search data, and sensing any change on the matchline with a matchline sense amplifier. In the case of a match condition, there are no current paths to ground, and the potential level of the matchline rises quickly to a predetermined threshold which is used to indicate the match condition. In the case of a miss, there will be at least one current path to groundand the potential level of the matchline rises more slowly to the predetermined threshold level. Accordingly, the matchline potential level rises at a rate depending on the number of resulting paths to ground. By precharging the matchline to ground, the voltage swing of the matchline is limited to a potential level between ground and the predetermined threshold level. This predetermined threshold level can be the switching point of an inverter for example, which is less than VDD. By combining this precharge-to-miss sensing scheme with the a segmented matchline structure described in Figure 5, further power can be saved because a matchline segment precharged to the miss state will remain at the miss state as long as its corresponding preceding matchline segment encounters a miss. Therefore in one embodiment of the present invention, each row of matchlines in a CAM array are segmented into pre-search matchlines and main search matchlines as shown in Figures 4 and 5, and a sensing scheme where the pre-search and main search matchlines are precharged to a miss state to reduce power consumption is used.

Figure 7 illustrates an embodiment of the low power CAM architecture according to the present invention. The low power CAM architecture uses segmented matchlines and a sensing scheme where the matchlines are precharged to a miss state. Furthermore, the sensing scheme uses reference matchlines to provide self-timed generation of control signals for controlling the matchline sense amplifiers and latch circuits coupled to each matchline. The CAM array **130** of Figure 7 can replace the array 25 shown in the CAM device of Figure 1, with corresponding modifications to the peripheral circuits, such as the search line drivers.

CAM array **130** of Figure 7 includes a pre-search array **131** and a main search array **132.** Although no memory array is shown in Figure 7, it will be understood by those skilled in the art that the term array used in this context refers to both the memory array as well as its associated control circuitry. The pre-search array **131** includes a plurality of pre-search matchlines and associated circuitry **133,** and a reference pre-search matchline circuit **137.** In this particular example of the present embodiment, 1 of **128** pre-search matchline rows **133** and the reference matchline circuit are shown. Each pre-search matchline row **133** includes a pre-search matchline **P_MLn,** a pre-search matchline sense amplifier **134** and a pre-search latch **135.** In this particular example of the present embodiment, there are 36 ternary CAM cells (not shown) connected to the pre-search matchline **P_MLn.** The pre-search matchline sense amplifier **134** senses the potential level of **P_MLn** and provides a local output signal **SPd** corresponding to a hit or miss condition to the pre-search latch 135. Pre-search latch **135** holds the state of the local output signal **SPd** and generates signal **Psrch_HIT**. Both the pre-search MLSA **134** and the pre-search latch **135** receive timed control signals from the reference pre-search matchline circuit **137** via a timing control circuit **136,** and pre-search MLSA **134** receives a reference voltage **VREF** generated by a reference voltage generator (not shown in Figure 7).

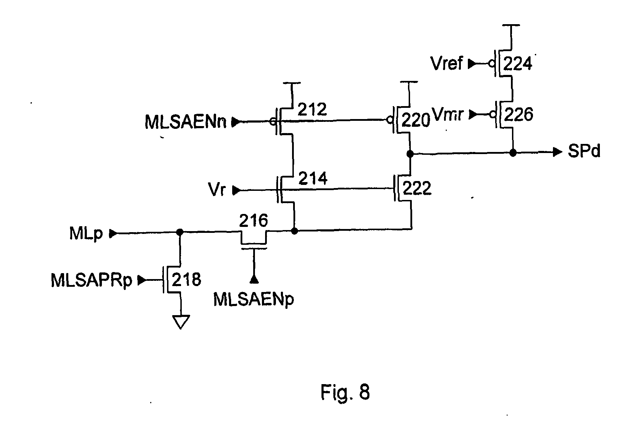

The reference pre-search matchline circuit includes a timing control circuit **136,** a reference pre-search matchline **P_RML**, a pre-search matchline sense amplifier MLSA **137** and an inverter **138.** In this particular example of the present embodiment, there is one reference pre-search matchline circuit for the pre-search array **131.** The reference pre-search matchline **P_RML** is identically configured to the pre-search matchline **P_MLn** to match the parasitic resistance and capacitance of the pre-search matchline **P_MLn,** except that all the search and compare transistors of the CAM cells are permanently turned off with the exception of one pair of search and compare transistors that are permanently turned on. The reference pre-search matchline is thus hardwired to simulate a single miss condition. Pre-search matchline sense amplifier MLSA **137** is identical to pre-search matchline sense amplifier MLSA **134,** for sensing the potential level of **P_RML**. Pre-search MLSA **137** also receives **VREF.** Instead of having a latch circuit at the output of the pre-search matchline sense amplifier **137** as is the case with the output of the pre-search matchline sense amplifier MLSA **134,** an inverter **138** receives the reference pre-search output **SPd** of pre-search MLSA **137.** Timing control circuit **136** receives as a feedback signal the output of inverter **138** and a matchline sense amplifier toggle signal **MLSATGLp[1]** and generates three signals for use by all pre-search NMSA's **134** and **137,** and two signals for use by all pre-search latches **135. MLSATGLp[1]** initiates sensing in the pre-search array **131.** Although not shown, timing control circuit **136** also receives a clock signal for synchronizing the search operation with a system clock. The three signals for use by all pre-search **MLSA's 134** and **137** are pre-search matchline sense enable signal **PMLSAENp** for NMOS devices, pre-search matchline sense enable signal **PMLSAENn** for PMOS devices, and **MLSAPRp** for the precharge devices. The matchline sense amplifier circuit of MLSA's **134** and **137** will be described in more detail with reference to Figure 8. The two signals for use by all pre-search latches **135** are **PLTCHn** and **PLTCHp.**

The general operation of the sensing scheme for the pre-search array **131** is now described for one search and compare cycle (a more detailed description of the operation of the matchline sense amplifier circuit will be provided later in the Description). All the pre-search matchlines **P_MLn** and **P_RML** are precharged to the miss state, which in this embodiment is the ground voltage during a prechage phase. After search data is asserted onto the searchlines (not shown), the matchline sense amplifier toggle signal **MLSATGLp[1]** is activated to initiate the sensing phase via signals **PMLSAENp, PMLSAENn** and **PMLSAPRp.** In the sensing phase, as will be described in more detail later with reference to the specific operation of a preferred embodiment of the matchline sense amplifier circuit, the **SPd** output of pre-search MLSA 137 is eventually driven from a high potential level to a potential level low enough to cause inverter **138** to switch and feedback a high logic level output to timing control circuit **136.** Timing control circuit **136** then turns off the pre-search MLSA's **134** and **137** to save power, and activates the matchline latching signals **PLTCHn** and **PLTCHp** to enable latching of the local **SPd** outputs from respective pre-search MLSA's **134.** Once the **SPd** outputs have been latched, timing control circuit **136** then has all the pre-search matchline sense amplifier circuits MLSA's **134** and **137** precharge all respective pre-search matchlines to the miss state of ground in preparation for the next search and compare cycle.

The time required for pre-search MLSA 137 to drive its **SPd** output to a potential level to switch the state of inverter **138** is determined by the configuration of pre-search reference matchline **P_RML.** More specifically the reference pre-search matchline row always simulates a worst case miss condition, i.e. a single bit miss. This is due to the fact that only one search and compare transistor pair is on while all the other search and compare transistors of **P_RML** are off. When a single miss occurs in any matchline, the single search and compare transistor pair generates a very small current, about 10µA which requires a relatively long time for the associated matchline sense amplifier to detect and subsequently drive its SPd output to a low potential level. If the pre-search MLSA's **134** and the pre-search MLSA **137** are simultaneously turned on after search data is asserted on the search lines, by the time the reference pre-search MLSA 137 has changed its **SPd** potential level, any MLSA **134** connected to a **P_MLn** with a match will already be in a state to drive its respective SPd output to a logic level indicative of a hit. This is because the rate at which the potential level of a match condition matchline rises is faster than the rate at which the potential level of a miss matchline rises. In this manner, by using the reference pre-search matchline to time the deactivation of all matchline sense amplifiers, the system ensures that the proper matchline search result data is being latched by the matchline latches.

The components of the main search array **132** of CAM array **130** will now be described in further detail. The main search array **132** includes a plurality of main search matchlines and associated circuitry **139,** and a reference main search matchline circuit. In this particular example of the present embodiment, each of the **128** main search matchline rows **139** corresponds to each of the **128** pre-search matchline rows **133.** Each main search matchline row **139** includes a main search matchline **M_MLn**, a main search matchline sense amplifier **140** a main search latch **141,** and an AND gate **142.** In this particular example of the present embodiment, there are 108 ternary CAM cells (not shown) connected to the main search matchline **M_MLm.** The main search matchline sense amplifier **140** senses the potential level **of M_MLn** and provides a local output signal **SPd** corresponding to a hit or miss condition to the main search latch **141.** Main search latch **141** holds the state of the local output signal **SPd** and generates signal ML_OUTn. As seen in Figure 7, the components of the main search array **132** are configured identically to the components of the pre-search array **131,** except that each main search matchline and associated circuitry **139** includes an AND gate **142.** While main search latch **141** and reference main search MLSA **144** receive the control signals from the timing control circuit **143,** main search MLSA's **140** do not directly receive the signals from timing control circuit **143.** AND gate **142** receives the three signals from timing control circuit **143,** and combines them with the result of the pre-search designated by signal **Psrch_HIT** from the pre-search latch **135** from pre-search array **133.** Those of skill in the art will understand that AND gate **142** represents three AND gates each of which receive one of the three control signals from control block **143** and the **Psrch_HIT signal,** and each AND gate **142** generates a control signal which is provided to the main search sense amplifier **140.** The AND gates **142** will enable passage of the three respective control signals when **Psrch_HIT** indicates that a hit has been detected in the pre-search matchline portion, i.e. is at the high logic level. In other words, a main search sense amplifier MLSA **140** will be prevented from receiving the three control signals if signal **Psrch_HIT** is at the low logic level, indicative of a miss condition. Hence a main search **MLSA 140** is inhibited from sensing changes in the main matchlines of main search array **132** if its corresponding pre-search matchline row **133** reports a miss condition. It will be understood by those skilled in the art that although AND gate **142** has been described as combining each control signal from the control block **143** with the **Psrch_HIT** signal, it is possible to combine only one or two of the control signals with the **Psrch_HIT** signal. For example, in one embodiment of the invention, only one of the three control signals provided by the control block **143** is combined with the Psrch_HIT signal to generate a control signal that is provided to the Msrch MLSA while the other two control signals generated by control block **143** are provided directly to the Msrch MLSA. Such an embodiment will be described in more detail with reference to Figure 8.

The reference main search matchline circuit includes a timing control circuit **143,** a reference main search matchline **M_RML,** a main search MLSA **144** and an inverter **145.** In this particular example of the present embodiment, there is one reference main search matchline circuit for the main search array **132**. The reference main search matchline **M_RML** is identically configured to the main search matchline **M_MLn** to match the parasitic resistance and capacitance of the main search matchline **M_MLn,** except that all the search and compare transistors of the CAM cells are permanently turned off with the exception of one pair of search and compare transistors that are permanently turned on. The reference main search matchline is thus hardwired to simulate a single miss condition. Main search MLSA **144** is identical to main search MLSA **140,** for sensing the potential level of **M_RML.** Main search MLSA **144** also receives reference voltage **VREF.** An inverter **145** receives the SPd output of main search MLSA **144.** Timing control circuit **143** receives the output of inverter **145** and a matchline toggle signal **MLSATGLp[2]** and generates three control signals for controlling all main search sense amplifiers MLSA's **140** and **144,** and two control signals for controlling all main search latches **141.** Although not shown, timing control circuit **143** also receives a clock signal for synchronizing the search operation with a system clock, thereby allowing for pipelining of the pre-search and main search operations. The three control signals for controlling all main search MLSA's **144** and **144** are **MLSAENp, MLSAENn** and **MLSAPRp**. The two control signals for controlling all main search latches **141** are **LTCHn** and **LTCHp.**

The general operation of the circuits of main search array **132** is the same as previously described for pre-search array **131,** and therefore the general operation of the circuits of main search array **132** will not be repeated. Of note however, is that toggle signal **MLSATGLp[2]** is activated after **MLSATGLp[1],** typically in a clock cycle following the cycle in which **MLSATGLp[1]** is activated. It should also be noted that signals **MLSAENp, MLSAENn, MLSAPRp,** LTCHn and **LTCHp** are equivalent in function to signals **PMLSAENp, PMLSAENn, PMLSAPRp, PLTCHn** and **PLTCHp** respectively for their respective arrays.

Figure 8 shows a circuit schematic of a matchline sense amplifier circuit according to another embodiment of the present invention. This matchline sense amplifier circuit can be used as the MLSA circuits **134, 137, 140** and **144** in Figure 7 in a preferred embodiment of the low power CAM array architecture invention.

The matchline sense amplifier circuit of Figure 8 includes a current source, a biasing circuit and a voltage limiting circuit. The current source includes p-channel transistors **224** and **226** serially connected between the voltage supply VDD and a sense output node SPd. The gate terminal of p-channel transistor **224** is connected to a first reference voltage Vref and the gate terminal of p-channel transistor **226** is connected to a second reference voltage Vmr. The biasing circuit includes p-channel transistors **212, 220** and n-channel transistors **214, 216** and **218.** P-channel transistor **212** and n-channel transistor **214** are serially connected between the supply voltage VDD and the drain terminal of n-channel transistor 216- P-channel transistor **220** and n-channel transistor 222 are serially connected between the supply voltage VDD and the drain terminal of n-channel transistor **216,** where the shared source/drain terminal of transistors 220 and 222 is connected to sense output node SPd. The gate terminals of p-channel transistors 212 and 220 are connected to matchline sense amplifier enable signal **MLSAENn**, and the gate terminals of n-channel transistors **214** and **222** are connected to limiting voltage Vr. N-channel transistors **216** and **218** are serially connected between the source terminals of n-channel transistors **214** and **222** and ground, where the shared source/drain terminal of transistors **216** and **218** is connected to an associated matchline **MLp.** It should be noted that **MLp** is equivalent to any one **of P_MLn, P_RML, M_MLn** and **M_RML,** because they are all matchlines that are to be sensed by the matchline sense amplifier circuit. The gate terminals of transistors **216** and **218** are connected to matchline sense enable signal **MLSAENp** and and matchline sense precharge signal **MLSAPRp** respectively. The voltage limiting circuit includes n-channel transistor 222 having the previously described configuration. Main search array control signals **MLSAENn, MLSAENp** and **MLSAPRp** are equivalent to pre-search array control signals **PMLSAENn, PMLSAENp** and **PMLSAPRp** respectively that were previously discussed with reference to Figure 7. Voltages Vref, Vr and Vmr are generated by other circuits in the CAM device, and are shown in Figure 7 as a single line labelled **VREF** to simplify the block diagram.

A description of the general function of the matchline sense circuit of Figure 8 follows. In general, as a result of a search and compare operation, the matchline MLp carries a voltage signal and an associated current, that is indicative of a match or mis-match condition after search data is applied onto the search lines. The associated matchline current will flow when at least one pair of search and compare transistors are turned on to couple **MLp** to ground. In order to sense a match or mis-match condition on a matchline according to the invention, a positive biasing point potential on matchline MLp is first established before search data is applied onto the search lines in order for the matchline current sense amplifier to detect any change in the matchline current as a result of the search operation.

During a precharge phase, matchlines are precharged to a precharge voltage, such as ground potential for example, when the matchline precharge signal **MLSAPRp** is logic high. At the same time, the matchline sense signals **MLSAENp** and **MLSAENn** are logic low and high respectively, isolating the matchline **MLp** from the sense node **SPd.**

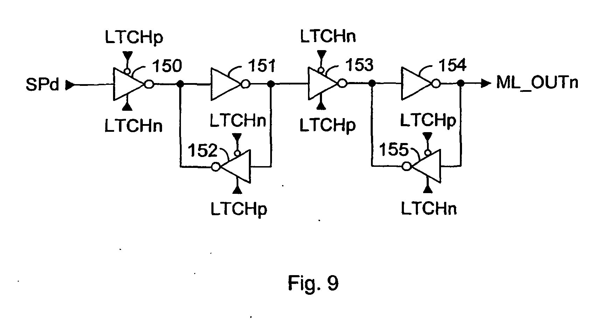

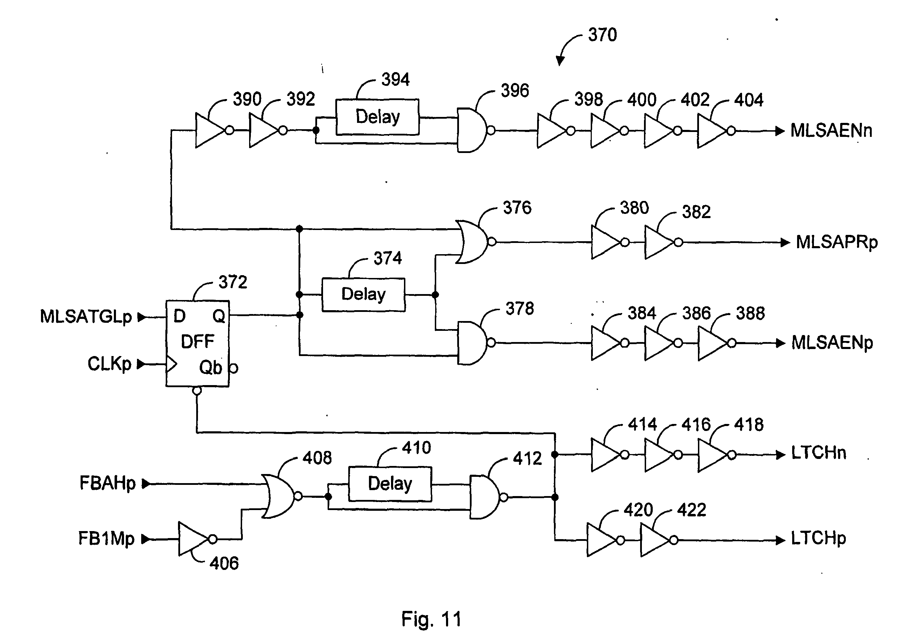

During the sensing phase, the precharging of matchlines ceases with **MLSAPRp** being pulled a logic low level, and current is provided to the matchline **MLp** with **MLSAENn** being pulled to low logic level and **MLSAENp** being pulled to a high logic level. Vr is at a predetermined potential level, typically about 0.5 volts. Under these conditions transistors **212, 214** and **216** are turned on while transistor **218** is turned off and biasing potentials are established on the matchline and the sense node **SPd.** It should be noted that transistors **214** and **222** receive limiting voltage **Vr,** which can be about 0.5 volts, for limiting the maximum potential of the matchline **MLp** to about 0.5 volts. Subsequently, **MLSAENn** is driven to the high logic level to turn off transistors 212 and 220. P-channel transistors **224** and **226** of the current source remain turned on to supply a small biasing current which is high enough to maintain **SPd** at VDD. In the present embodiment, the biasing current supplied by the current source is a fraction of the current generated when one pair of search and compare transistors is turned on. This particular feature of the present embodiment is discussed later. After search data is applied to the search lines, at least one or zero search and compare transistor pairs are turned on. If at least one pair of search and compare transistors is turned on, then a matchline current will flow from **MLp** to ground. This matchline current will be larger than the biasing current supplied by the current source, and pulls down the sense node **SPd** through transistors 222 and **216.** If no search and compare transistor pairs are turned on to indicate a match condition, then the potential level of MLp remains at the precharge potential of Vr due to the presence of voltage limiting transistor 222. Correspondingly, **SPd** remains at VDD. A latch circuit such as the one shown in Figure 9 does not latch the potential on **SPd** until complementary latch signals **LTCHp** and **LTCHn** become active at a predetermined period of time after search data is driven onto the searchlines. After this predetermined period of time, the potential level of SPd is either above or below the flip point of tri-state inverter **150,** and the complementary latch signals **LTCHp** and **LTCHn** are pulsed to their active states by the control circuit of Figure 11. Depending upon the potential of SPd relative to the tri-state inverter 150 flip point, tri-state inverter 150 will either drive a high or low logic level at its output. When the **LTCHp** and **LTCHn** pulses end, tri-state inverter **150** is turned off. Once the sensing operation has finished, signal **MLSAENp** is driven to the low logic potential level to turn off transistor **216** and signal **MLSAPRp** is driven to the high logic potential level to turn on transistor **218,** thereby bringing the associated matchline **MLp** to its precharge level once again.

It should be noted that in an alternate embodiment of the matchline sense circuit shown in Figure 4, transistors **212** and **214** are omitted and the width of transistors **220** and **222** are adjusted to compensate for the removal of the current path provided by transistors **212** and **214.**

Figure 9 shows a circuit schematic of a latch circuit that can be used as latches **135** and **141** from Figure 7. This latch circuit is a standard flip-flop type latch circuit, and includes a pair of cross-coupled inverters. The latch circuit of Figure 9 includes a tri-state inverter **150** having an input coupled to the **SPd** output of a matchline sense amplifier circuit and an output connected to a first cross-coupled pair of inverters. The first cross-coupled pair of inverters includes inverter **151** and tri-state inverter **152.** The output of inverter **151** is connected to tri-state inverter **153,** whose output is then connected to a second cross-coupled pair of inverters. The second cross-coupled pair of inverters includes inverter **154** and tri-state inverter **155.** If this latch circuit is used as main search latch **141,** then the output of inverter **154** drives output **ML_OUT.** If this latch circuit is used as pre-search latch **135,** then the output of inverter **154** would drive output **Psrch_HIT.** Complementary latch signals **LTCHp** and **LTCHn** are connected to the tri-state inverters in a configuration that permits the potential level of **SPd** to be sensed, and then shifted from the first cross-coupled pair of inverters to the second cross-coupled pair of inverters as **LTCHp** is toggled between the high and low logic levels. This type of latch circuit is well known in the art, and therefore its method of operation does not require further discussion.

According to another embodiment of the present invention, pre-search and main search operations are pipelined to maintain high throughput with a cycle latency of one. Figure 10 is a timing diagram showing pipelining operations for successive search operations. The timing diagram of Figure 10 is discussed with reference to Figures 8 to 10. A pre-search begins for a first search word in cycle 3, and the result of the pre-search MLSA **134** is eventually latched and driven as signal **Psrch_HIT** from pre-search latch **135.** More specifically, the data is latched in the first cross-coupled pair of inverters of pre-search latch **135.** The main search for the first search word begins for the first search word in cycle 4 if the logic level of its corresponding **Psrch_HIT** is at the high logic level. A pre-search for a second search word also begins in cycle 4 as the main search for the first search word commences. This second pre-search operation can be executed because as complementary latch signals **PLTCHp** and **PLTCHn** are activated at the low and high logic levels respectively to sense the new **SPd** data for the second search word, tri-state inverter **153** of the latch circuit of Figure 9 turns off. Furthermore, the previous SPd data is latched in the second cross-coupled pair of inverters to maintain the previous logic level of **Psrch_HIT** for the main search of the first search word. In cycle 5, the main search is conducted for the second search word and a pre-search for a third search begins. The main search for the third search word begins in cycle 6, and there is no further pre-search to be conducted. Therefore, because of the pipelining scheme described above, there is no requirement for an additional cycle between every search and compare operation for the pre-search operation. Hence overall CAM operating speed can be increased relative to a structure not having matchline segmentation since pre-search and main search operations are executed in parallel.

The embodiment of the matchline sense amplifier shown in Figure 8 can be used in both non-segmented as well as segmented matchline architectures to save power.

Figure 11 shows a circuit schematic of a control block that generates the signals for controlling the sense amplifier of Figure 8 with proper timing. A flip-flop circuit **372** receives matchline sense amplifier toggle signal **MLSATGLp** at its D input and clock signal **CLKp** at its clock input. The Q output of flip-flop **372** is connected to respective first inputs of NOR gate **376** and NAND gate **378** and the input of a non-inverting delay block 374. The output of delay block **374** is connected to respective second inputs of NOR gate **376** and NAND gate **378.** The output of NOR gate **376** is connected to a pair of serially connected inverters, **380** and **382,** for driving signal **MLSAPRp.** The output of NAND gate **378** is connected to three series connected inverters, **384, 386** and **388,** for driving signal **MLSAENp.** The Q output of flip-flop **372** is also connected to a pair of serially connected inverters **390** and **392,** whose output is connected to the input of inverting delay block **394** and an input of NAND gate **396.** The output of inverting delay block **394** is connected to the other input of NAND gate **396.** The output of NAND gate **396** is connected to four series connected inverters, **398, 400, 402** and **404,** for driving signal **MLSAENn.** Signal **FB1Mp** is coupled to one input of NOR gate **408** through inverter **406.** Signal **FBAHp** is connected to the other input of NOR gate **408.** The output of NOR gate **408** is connected to the input of inverting delay block **410** and one input of **NAND** gate **412,** while the output of inverting delay block **410** is connected to the other input of NAND gate **412.** The output of NAND gate **412** is connected to three serially connected inverters **414, 416** and **418** for driving signal **LTCHn,** and a pair of serially connected inverters **420** and **422** for driving signal **LTCHp.** The output of NAND gate **412** is also connected to the reset input of flip-flop **372.** Delay blocks **374, 394** and **410** will delay propagation of both high and low logic level signals. Inverting delay blocks **394** and **410** can include any odd number of inverting elements, such as inverters, NOR gates or NAND gates, or a combination of an odd number of inverting elements and capacitors and resistors. Non-inverting delay block **374** can include any even number of inverting elements or combination of an even number of inverting elements and capacitors and resistors. The delay provided by delay blocks **374, 394** and **410** can be programmable after fabrication through trimming, for example.

In general, operation of the control block **370** is as follows. It should be assumed that the Q output from flip-flop 372 in the initial inactive state is at the low logic level, **MLSAENn, MLSAPRp** and **LTCHp** are at the high logic level, and **MLSAENp** and LTCHn are at the low logic level. A high logic level **MLSATGLp** pulse received by flip-flop **372** initiates control signal generation. Flip-flop **372** drives its Q output to the high logic level in response to the high logic level **MLSATGLp** on the rising edge of clock signal **CLKp.** The output of NOR gate **376** is then driven to the low logic level, and **MLSAPRp** is subsequently driven to the low logic level by inverter **382.** After the delay provided by non-inverting delay block **374,** both inputs of NAND gate **378** are at the high logic level to drive its output to the low logic level. **MLSAENp** is subsequently driven to the high logic level by inverter **388.** The high logic level Q output of flip-flop **372** also drives the input of inverter **390,** causing inverter **392** to output a high logic level. The high logic level output of inverter **392** is received by inverting delay block **394** and an input of NAND gate **396.** Since the output of inverting delay block **394** is currently at the high logic level, both inputs of NAND gate **396** are at the high logic level to drive MLSAENn from a high to low logic level. Eventually, the high logic level received at the input of inverting delay block **394** is inverted at its output, forcing NAND gate **396** to output a high logic level signal. Therefore, **MLSAENn** pulses low in response to a high logic level Q output from flip-flop **372.**

The circuits described above relate to the generation of control signals **MLSAENn, MLSAPRp** and **MLSAENp** for allowing the MLSA circuit of Figure 8 to precharge and sense its respective matchline potential level. The following description of the remaining circuits of control block **370** relate to turning off the MLSA circuit of Figure 8. Feedback signal **FBAHp** remains at the low logic level during normal operations, but feedback signal **FB1Mp** eventually changes from an initial low logic level to a high logic level to indicate the presence of a single miss condition on its respective matchline. NOR gate **408** provides a high logic level output when both its inputs are at the low logic level. The high logic level output from NOR gate **408** is received by one input of NAND gate **412** and the input of inverting delay block **410.** Since the output of inverting delay block **410** is currently at the high logic level, both inputs of NAND gate **412** are at the high logic level to drive **LTCHn** from a low to high logic level, and **LTCHp** from a high to low ' logic level. Eventually, the high logic level received at the input of inverting delay block **410** is inverted at its output, forcing NAND gate **412** to output a high logic level signal. Therefore, **LTCHn** pulses high and LTCHp pulses low in response to a low logic level **FB1Mp** signal. Additionally, the low logic level pulse from the output of NAND gate **412** resets flip-flop **372** to drive the control signals **MLSAENn, MLSAPRp** and **MLSAENp** to their initial inactive states.

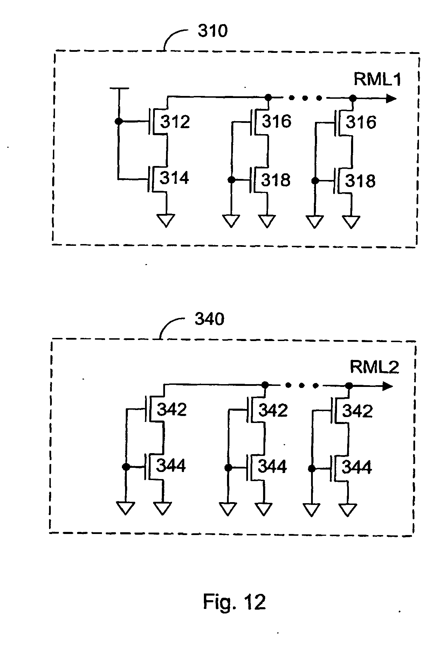

The previous paragraph illustrates the behaviour of the control block 370 in response to receiving a low logic level feedback signal **FB1Mp,** which is set to occur at a predetermined time after search data is asserted onto the searchlines of the CAM array. This preset time, or delay, is determined by the hardwired single miss matchline block **310.** The hardwired single miss, matchline block **310** is discussed in further detail with reference to Figure 12.

Figure 12 shows a schematic of hardwired single miss matchline row **310.** The electrical characteristics of the single miss reference matchline row **310** are intended to be the same as a normal matchline row. Matchline row **310** includes a reference matchline **RML1** having a plurality of serially connected n-channel search and compare transistors **312, 316** and **314, 318** respectively, connected between it and a tail line, or in this particular embodiment ground. **RML1** is identical in size to **MLp** in Figure 8, and search and compare transistors **312, 316** and **314, 318** are identical to corresponding search and compare transistors that would be connected to **MLp** in Figure 8. **RML1** also has the same number of search and compare transistor pairs as **MLp** to ensure accurate matching of electrical characteristics with a matchline row. In matchline block 310, only the gates of transistors **312** and **314** are connected to VDD while the gates of all other transistors **316** and **318** are grounded. The reason for this configuration is to mimic a normal matchline having exactly one miss condition. Figure 12 also shows a schematic of hardwired hit matchline row **340.** The electrical characteristics of hit matchline row **340** are intended to be same as normal matchline row **240,** and is identical to single miss matchline row **310.** Search and compare transistors **342** and **344** are identical to corresponding search and compare transistors of row **310,** except that the gates of all transistors **342** and **344** are grounded to keep them turned off.

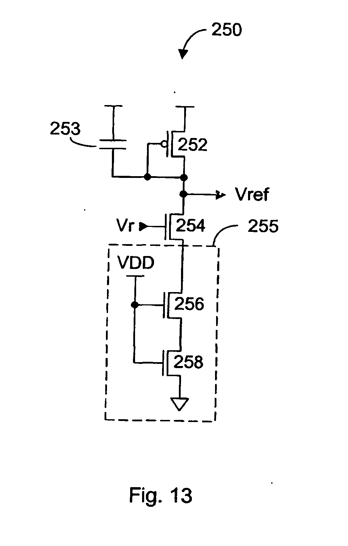

The current source circuit of the embodiment of Figure 8 is now described in further detail. As previously mentioned, the current source having p-channel transistors **224** and **226** provides a small current sufficient in magnitude to maintain the VDD potential level on **SPd** in the absence of a miss condition current on its corresponding matchline. According to a feature of the present embodiment, this small current is a fraction of the current produced by one pair of search and compare transistors in the on state. This is achieved by applying a predetermined reference voltage Vref on the gate of p-channel transistor **224.** Voltage **Vmr** connected to the gate of p-channel transistor **226** is a constant voltage used as an offset voltage for the cascode current mirror configuration. The generation of **Vref** is further discussed with reference to Figure 13.

Figure 13 is a circuit schematic embodiment of a voltage reference circuit for providing **Vref.** The reference voltages **Vref** and **Vmr** are provided to all MLSA (matchline sense amplifier) circuits as well as the reference MLSA circuits. Voltage reference circuit **250** includes a p-channel diode connected load transistor 252 and a reference voltage limiting n-channel transistor **254** serially connected between VDD and a dummy cell **255. Vref** is coupled to VDD through capacitor **253.** Dummy cell **255** includes two n-channel transistors 256 and **258** connected in series between the source terminal of transistor **254** and ground. Transistors **256** and **258** are constructed identically to a normal pair search and compare transistors, such as search and compare transistors **312** and **314** of figure 12. The gate terminal of reference voltage limiting n-channel transistor **254** is connected to predetermined voltage Vr, and the gate terminals of transistors **256** and **258** are connected to VDD. Because the dummy search and compare transistors **256** and **258** are the same as normal search and compare transistors, the current they generate will be the same. Furthermore, changes in the operating conditions will affect both the normal and dummy search and compare transistors in the same way. The current of transistor 224 can be increased or decreased in the design stage by scaling the W/L ratio of transistors **224** and **252.** In the present embodiment, the current through transistor **224** can be changed by scaling its W/L ratio as a factor of the W/L ratio of or transistor **252.** For example, the W/L ratio of transistor **224** can be between 0.1 to 0.5 of the W/L ratio of transistor **252. Vr** is provided by a separate voltage generator (not shown), and is determined as the difference between a voltage level at which one pair of search and compare transistors develops a pull-down current large enough to be sensed and the threshold voltage of transistor **216** from Figure 13. **Vr** is typically about 0.4 to 0.5 volts.

The power saving features of the present embodiment are now described. The sensing cycle typically begins at a clock pulse but ends before the subsequent clock pulse, leaving idle time between the end of the sense cycle and the beginning of the next clock pulse. Therefore if transistor **216** of Figure 8 remained in the on state or was not present in the circuit, static power is continually consumed in matchlines having the miss condition because of the path to ground in the matchline **MLp.** By turning off transistor **216** shortly after the sense cycle ends, the current source is disconnected from the path to ground in the miss condition matchline. Voltage limiting transistor **222,** and similarly transistor **214,** having its gate terminal connected to Vr isolates the full VDD potential **of SPd** from **MLp,** and limits **MLp** to about **Vr.** Therefore, the voltage swing of **MLp** is always limited **to Vr** during the entire sense cycle and power consumption due to repeated charge and discharge of **MLp** is minimized.

The matchline sense amplifier embodiment of the present invention is a compact circuit consisting of no more than eight transistors for fitting into the tight pitch CAM core layout. The circuit can sense small currents of about 10µA within a short clock cycle, and limits matchline voltage levels to a low level for reducing power dissipation.

Therefore, as shown by the embodiments of the present invention, a low power CAM array can be achieved by segmenting matchlines into a pre-search array and a main search array, and implementing a sensing scheme where the matchlines of the pre-search and main search arrays are first precharged to a precharge level and then biased to an operating point before matchline data is sensed by matchline sensing circuitry. Additionally, by segmenting matchlines into two shorter matchlines, the parasitic capacitance and resistance encountered by each matchline sense amplifier is reduced. Therefore, less power is consumed and matchline sensing speed can be improved.

Of course, numerous variations and adaptations may be made to the particular embodiments of the invention described above, without departing from the scope of the invention, which is defined in the claims.

While the matchline sense circuit of the present invention has been implemented and simulated using CMOS technology on silicon, alternative embodiments can be implemented in other technologies such as BiCMOS. In alternative embodiments, the matchlines can be segmented into three or more segments and associated pipeline latch stages with a matchline sense amplifier output forward feeding into the next matchline sense amplifier to enable further sensing.

The above-described embodiments of the invention are intended to be examples of the present invention. Alterations, modifications and variations may be effected the particular embodiments by those of skill in the art, without departing from the scope of the invention which is defined solely by the claims appended hereto.

## Claims

1. A content addressable memory array comprising:
a matchline divided into a plurality of segments, each of the plurality of segments simultaneously precharged to a precharge voltage level in a precharge phase;
**characterized by**
a matchline sense amplifier associated with each of the segments for sensing current from its associated segment in a sensing phase, one matchline sense amplifier enabling another matchline sense amplifier when a match condition is detected by the one matchline sense amplifier.

2. The CAM array of claim 1, wherein timing circuits control precharge and sensing operations of the matchline sense amplifiers.

3. The CAM array of claim 2, wherein the timing circuits include reference matchlines.

4. The CAM array of claim 1, wherein the precharge voltage level corresponds to a miss condition.

5. The CAM array of claim 1, wherein the precharge voltage level is ground.

6. The CAM array of claim 1, wherein the matchline includes a first and a second matchline segment.

7. The CAM array of claim 6, wherein the matchline sense amplifier associated with the first matchline segment enables the matchline sense amplifier associated with the second matchline segment.

8. The CAM array of claim 7, wherein the first matchline segment is coupled to fewer content addressable memory cells than the second matchline segment.

9. The CAM array of claim 1, wherein the output of each matchline sense amplifier is stored in a latch circuit.

10. A method of searching a content addressable memory having a plurality of rows of CAM cells, each row having first and second matchline segments, the method
**characterised by**;
(a) precharging the first and second match line segments to a potential level corresponding to a miss condition during a precharge phase;
(b) establishing a biasing potential on the first matchline segment in each row of CAM cells during a sensing phase;
(c) sensing current in the first matchline segment during the sensing phase; and,
(d) selectively enabling sensing of current in the second matchline segment in each row of CAM cells if the sensed current in the first matchline segment corresponds to a match condition between the search data and the stored data.

11. The method of claim 10, wherein the step of selectively enabling sensing includes converting the sensed current into a sense node output voltage.

12. The method of claim 11, wherein the step of selectively enabling sensing includes latching the sense node output voltage for pipelined sensing of current in the first and the second matchline segments.

## Patentansprüche

1. Inhaltsadressierbares Speicher-Array mit:
einer Paßgenauigkeitsleitung, die in eine Vielzahl von Segmenten geteilt ist, wobei ein jedes von der Vielzahl von Segmenten gleichzeitig auf einen Vorladungsspannungspegel in einer Vorladungsphase vorgeladen wird;
**gekennzeichnet durch**:
einen Paßgenauigkeitsleitungsleseverstärker, der einem jeden der Segmente zugeordnet ist, zum Lesen des Stroms von seinem zugeordneten Segment in einer Lesephase, wobei ein Paßgenauigkeitsleitungsleseverstärker einen anderen Paßgenauigkeitsleitungsleseverstärker freigibt, wenn eine Paßgenauigkeitsbedingung **durch** den einen Paßgenauigkeitsleitungsleseverstärker detektiert wird.

2. CAM-Array nach Anspruch 1, bei dem Zeitgeberschaltungen das Vorladen und Leseoperationen der Paßgenauigkeitsleitungsleseverstärker steuern.

3. CAM-Array nach Anspruch 2, bei dem die Zeitgeberschaltungen Referenz-Paßgenauigkeitsleitungen enthalten.

4. CAM-Array nach Anspruch 1, bei dem der Vorladungsspannungspegel einer Fehlbedingung entspricht.

5. CAM-Array nach Anspruch 1, bei dem der Vorladungsspannungspegel Erde ist.

6. CAM-Array nach Anspruch 1, bei dem die Paßgenauigkeitsleitung ein erstes und ein zweites Paßgenauigkeitsleitungssegment enthält.

7. CAM-Array nach Anspruch 6, bei dem der Paßgenauigkeitsleitungsleseverstärker, der dem ersten Paßgenauigkeitsleitungssegment zugeordnet ist, den Paßgenauigkeitslesaverstärker freigibt, der dem zweiten Paßgenauigkeitsleitungssegment zugeordnet ist.

8. CAM-Array nach Anspruch 7, bei dem das erste Paßgenauigkeitsleitungssegment mit weniger inhaltsadressierbaren Speicherzellen als das zweite Paßgenauigkeitsleitungssegment gekoppelt ist.

9. CAM-Array nach Anspruch 1, bei dem die Ausgabe eines jeden Paßgenauigkeitsleitungsleseverstärkers in einer Verriegelungsschaltung gespeichert wird.

10. Verfahren zum Durchsuchen eines inhaltsadressierbaren Speichers, der eine Vielzahl von Reihen von CAM-Zellen hat, wobei jede Reihe erste und zweite Paßgenauigkeitsleitungssegmente hat, welches Verfahren **gekennzeichnet ist durch**:
(a) Vorladen der ersten und zweiten Paßgenauigkeitsleitungssegmente auf einen Potentialpegel, der einer Fehlbedingung entspricht, während einer Vorladungsphase;
(b) Aufbauen eines Vorspannungspotentials auf dem ersten Paßgenauigkeitsleitungssegment in jeder Reihe von CAM-Zellen während einer Lesephase;
(c) Lesen des Stroms in dem ersten Paßgenauigkeitsleitungssegment während der Lesephase; und
(d) selektives Freigeben des Lesens des Stroms in dem zweiten Paßgenauigkeitsleitungssegment in jeder Reihe von CAM-Zellen, falls der gelesene Strom in dem ersten Paßgenauigkeitsleitungssegment einer Paßgenauigkeitsbedingung zwischen den Suchdaten und den gespeicherten Daten entspricht.

11. Verfahren nach Anspruch 10, bei dem der Schritt zum selektiven Freigeben des Lesens das Konvertieren des gelesenen Stroms in eine Leseknotenausgangsspannung enthält.

12. Verfahren nach Anspruch 11, bei dem der Schritt zum selektiven Freigeben des Lesens das Verriegeln der Leseknotenausgangsspannung zum Pipeline-Lesen des Stroms in den ersten und zweiten Paßgenauigkeitsleitungssegmenten enthält.

## Revendications

1. Matrice mémoire adressable par le contenu comprenant :
une ligne de correspondance divisée en une pluralité de segments, chacun de la pluralité de segments étant simultanément pré-chargé à un niveau de tension de pré-charge lors d'une phase de pré-charge ;
**caractérisée par**
un amplificateur de lecture de ligne de correspondance associé à chacun des segments pour lire le courant provenant de son segment associé lors d'une phase de lecture, un amplificateur de lecture de ligne de correspondance activant un autre amplificateur de lecture de ligne de correspondance lorsqu'un état de correspondance est lu par le premier amplificateur de lecture de ligne de correspondance.

2. Matrice CAM selon la revendication 1, dans laquelle des circuits de synchronisation commandent les opérations de pré-charge et de lecture des amplificateurs de lecture de ligne de correspondance.

3. Matrice CAM selon la revendication 2, dans laquelle les circuits de synchronisation comprennent des lignes de correspondance de référence.

4. Matrice CAM selon la revendication 1, dans laquelle le niveau de tension de pré-charge correspond à un état d'insuccès.

5. Matrice CAM selon la revendication 1, dans laquelle le niveau de tension de pré-charge est la masse.

6. Matrice CAM selon la revendication 1, dans laquelle la ligne de correspondance comprend un premier et un deuxième segments de ligne de correspondance.

7. Matrice CAM selon la revendication 6, dans laquelle l'amplificateur de lecture de ligne de correspondance associé au premier segment de ligne de correspondance active l'amplificateur de lecture de ligne de correspondance associé au deuxième segment de ligne de correspondance.

8. Matrice CAM selon la revendication 7, dans laquelle le premier segment de ligne de correspondance est couplé à moins de cellules mémoire adressables par le contenu que le deuxième segment de ligne de correspondance.

9. Matrice CAM selon la revendication 1, dans laquelle la sortie de chaque amplificateur de lecture de ligne de correspondance est stockée dans un circuit à verrouillage.

10. Procédé de recherche dans une mémoire adressable par le contenu ayant une pluralité de rangées de cellules CAM, chaque rangée ayant des premier et deuxième segments de ligne de correspondance, le procédé étant **caractérisé par** :
(a) la pré-charge des premier et deuxième segments de ligne de correspondance à un niveau de potentiel correspondant à un état d'insuccès lors d'une phase de pré-charge ;
(b) l'établissement d'un potentiel de polarisation sur le premier segment de ligne de correspondance dans chaque rangée de cellules CAM lors d'une phase de lecture ;
(c) la lecture du courant dans le premier segment de ligne de correspondance lors de la phase de lecture ; et,
(d) l'activation sélective de la lecture du courant dans le deuxième segment de ligne de correspondance dans chaque rangée de cellules CAM si le courant lu dans le premier segment de ligne de correspondance correspond à un état de correspondance entre les données de recherche et les données stockées.

11. Procédé selon la revendication 10, dans lequel l'étape d'activation sélective de la lecture comprend la conversion du courant lu en une tension de sortie de noeud de lecture.

12. Procédé selon la revendication 11, dans lequel l'étape d'activation sélective de la lecture comprend le verrouillage de la tension de sortie de noeud de lecture pour la lecture « pipelinée » du courant dans le premier et le deuxième segments de ligne de correspondance.
